# FASCICULE DE BREVET EUROPEEN

(11) **EP 3 063 180 B1**
(45) Date de publication et mention de la délivrance du brevet: **18.08.2021**
(21) Numéro de dépôt: 14830402.5
(22) Date de dépôt: 29.10.2014
(51) Int. Cl.: C08F 2/00, C08J 5/00, C09K 11/00, C08F 8/30, C08K 3/04, C08G 61/12, C08F 291/14, C08K 7/06, C08K 7/24, C08L 65/00, H01B 1/12, H01L 51/00, H01M 10/00

(54) **COMPOSITIONS STABLES DE POLY (3,4-ETHYLENEDIOXYTHIOPHENE) ET DE STABILISANTS ANIONIQUES A ACIDITÉ LIMITÉE**
STABILE ZUSAMMENSETZUNGEN MIT POLY(3,4-ETHYLENDIOXYTHIOPHEN) UND ANIONISCHE STABILISATOREN MIT BEGRENZTER AZIDITÄT
STABLE COMPOSITIONS COMPRISING POLY (3,4-ETHYLENEDIOXYTHIOPHENE) AND ANIONIC STABILISERS WITH LIMITED ACIDITY

(30) Priorité: 31.10.2013 FR 1360684
(43) Date de publication de la demande: 07.09.2016
(73) Titulaire: Arkema France, 92700 Colombes (FR); Centre National de la Recherche Scientifique, 75794 Paris Cedex 16 (FR); Université de Bordeaux, 33000 Bordeaux (FR); Institut Polytechnique de Bordeaux, 33402 Talence Cedex (FR)
(72) Inventeur: NAVARRO, Christophe, F-64100 Bayonne (FR); SMAAL, Wiljan, F-33400 Talence (FR); MUMTAZ, Muhammad, F-33300 Bordeaux (FR); CLOUTET, Eric, F-33130 Begles (FR); BROCHON, Cyril, F-33700 Merignac (FR); HADZIIOANNOU, Georges, F-33850 Leognan (FR)
(74) Mandataire: Novagraaf Technologies
(86) Numéro de dépôt international: PCT/FR2014/052750
(87) Numéro de publication internationale: WO 2015/063416

(56) Documents cités:
- WO-A1-03/055919
- WO-A1-2005/095466
- WO-A1-2013/034848
- WO-A1-2013/150242
- WO-A2-2012/042492
- JP-A- 2010 062 059
- US-A1- 2011 288 241
- None

## Description

L'invention concerne une composition de poly(3,4-éthylènedioxythiophène)- stabilisants anioniques stables et présentant un degré d'acidité limité.

Le poly(3,4-éthylènedioxythiophène) connu sous l'abréviation PEDOT est un polymère qui a été découvert dans les laboratoires de Bayer AG en Allemagne, en collaboration avec le groupe AGFA, à la fin des années 1980. Il est utilisé en particulier dans les applications d'électronique organique, notamment dans les cellules photovoltaïques, mais d'une façon plus générale, dans les applications optoélectroniques, en raison de sa bonne conductivité et en particulier en raison de sa stabilité à l'oxydation et de sa transparence.

Le document WO2013/150242 divulgue des copolymères à blocs permettant une bonne dispersion de nanocharges dans l'eau ainsi qu'une dispersion de nanocharges obtenues grâce à ces copolymères à blocs. Cette dispersion est décrite comme pouvant être utilisée comme électrode transparente dans des cellules solaires organiques ou d'autres dispositifs photoémetteurs ou photorécepteurs.
Le document US2011/288241 divulgue un copolymère dibloc donneur-accepteur tige-bobine pour une cellule solaire organique et un procédé de synthèse de celui-ci.
Le document WO2012/042492 divulgue une composition polymère ayant des propriétés conductrices comprenant: (a) au moins une dispersion ou suspension d'élastomère ayant une Tg g <20 ° C, et / ou une solution polymère, (b) au moins un polythiophène éventuellement substitué polymère conducteur, substitué polymère conducteur, (c) particules de polymère réticulé ou non réticulé choisi parmi les particules fonctionnalisées ou non de polystyrène, de polycarbonate, de polyméthylène mélamine, lesdites particules de polymère non réticulé ayant une Tg> 80 ° C, les particules de verre, les particules de silice et / ou les particules d'oxydes métalliques choisis parmi les oxydes métalliques suivants: ZnO, MgO, MgA12O4, et les particules de borosilicate.
Le document JP2010/062059 divulgue une électrode transparente équipée d'une couche conductrice transparente sur un matériau de base transparent, la couche conductrice transparente est structurée de fibre conductrice et d'un matériau conducteur, le matériau conducteur contient au moins un polyanion avec une distribution de poids moléculaire (Mw / Mn) de 1,03 à 1,30.
Le document WO2013/034848 divulgue un copolymère dibloc BA ou tribloc BAB, dans lequel le bloc A est une chaîne polyoxyéthylène non substituée ayant un poids moléculaire moyen qui n'est pas supérieur à 100 kDa, et le bloc B est un polymère anionique qui peut être préparé en utilisant un ou plusieurs monomères choisis parmi les monomères vinyliques et leurs dérivés, lesdits monomères étant substitués par un anion (trifluorométhylsulfonyl) imide (TFSI).
Le document WO2005/095466 divulgue des composés soufrés, leur production par un procédé mis en œuvre en milieu aqueux et leur utilisation sous forme d'agents de transfert dans un procédé de polymérisation radicalaire contrôlée de l'acide acrylique et / ou de l'acide acrylique avec une solution hydrosoluble.
Le document WO03/055919 divulgue un procédé de préparation d'une dispersion aqueuse de particules de polymère comprenant les étapes suivantes: (i) préparation d'une dispersion ayant une phase aqueuse continue, une phase organique dispersée comprenant un ou plusieurs monomères éthyléniquement insaturés, et un agent RAFT amphiphile comme stabilisant pour ladite phase organique, et (ii) polymériser lesdits un ou plusieurs monomères éthyléniquement insaturés sous le contrôle dudit agent RAFT amphiphile pour former ladite dispersion aqueuse de particules de polymère, des agents RAFT amphiphiles à utiliser dans ce procédé, des agents RAFT utiles dans la fabrication ces agents amphiphiles RAFT et leurs procédés de fabrication.

Le PEDOT est un polymère insoluble dans les solvants usuels. Il est généralement associé à un copolymère poly (styrène-co- styrène sulfonique acide) (PSS) ce qui permet de le disperser dans l'eau. Le PSS agit comme un dopant de charges, formant des particules colloïdales consistant en un enchevêtrement de chaines PSS reliées au PEDOT, avec un cœur riche en PEDOT recouvert d'une couronne riche en PSS. Ces particules sont disponibles commercialement avec différents degrés de conductivité. Le PEDOT:PSS peut facilement être déposé sous forme de film mince par des méthodes communes telles que le « spin-casting » ou par impression du type « jet d'encre ». Dans beaucoup de dispositifs opto-électroniques, les couches de PEDOT:PSS sont disposées entre une couche d'électrode composée d'oxyde d'indium et d'étain (ITO) et d'une couche d'un matériau organique actif. Le PEDOT:PSS procure une meilleure fonction de l'électrode, lisse la surface rugueuse de l'ITO et par conséquent limite les courts circuits, et il protège la couche organique active de l'indium libre et de l'oxygène, conférant au système une durée de vie allongée.
Malheureusement, la nature même de la composition PEDOT:PSS présente des désavantages. En particulier, les dispersions colloïdales de PEDOT:PSS sont fortement acides et sont la cause potentielle de dégradation des couches adjacentes. Pour contourner ce problème, il est nécessaire de remplacer le PSS qui est très acide par un autre poly-électrolyte tout en conservant les avantages du PEDOT:PSS, en particulier la stabilité de la dispersion.

A l'issue de nombreux tests, la demanderesse à découvert une famille de stabilisants polyanions (Pan) permettant d'assurer la fonction de dopant de charges, autorisant une très bonne stabilité des dispersions colloïdales avec le PEDOT, tout en limitant l'acidité de ces dispersions colloïdales. Les films résultants sont à la fois faciles à fabriquer, présentent une bonne conductivité électrique et de bonnes propriétés mécaniques.

### Résumé de l'invention :

La présente divulgation concerne une composition PEDOT:polyanion dans laquelle le polyanion comprend des monomères qui répondent à la formule suivante I :

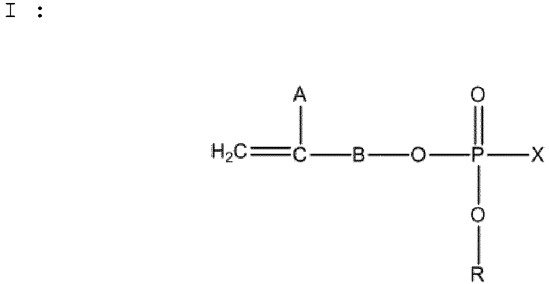

| | |
|---|---|
| A = H, CH₃ | |
| 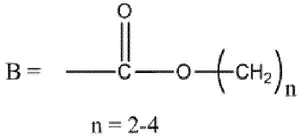 | ou groupe aryle |
| R = groupe alkyle ou aryle | |
| 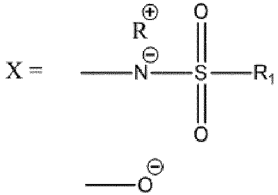 | R1 = CF₃, CH₃, F |
| 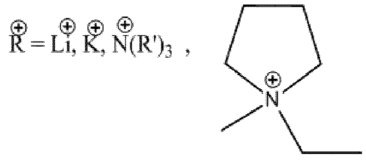 | ,R'= groupe aryle |

La présente invention concerne une composition PEDOT:polyanion dans laquelle le polyanion comprend le monomère 4-styrène-sulfonyle (trifluorométhyle-sulfonyle) imide de potassium.

### Description détaillée :

Les PAn utilisés dans les compositions de l'invention sont obtenus par polymérisation radicalaire ou par polymérisation radicalaire contrôlée de monomères I en présence éventuelle de co monomères ioniques ou non ioniques.

Les monomères copolymérisés éventuellemnt avec I sont choisis parmi les vinyliques, vinylidéniques, diéniques, oléfiniques, allyliques ou (méth)acryliques. Ces monomères sont choisis plus particulièrement parmi les monomères vinylaromatiques tels que le styrène ou les styrènes substitués notamment l'alpha-méthylstyrène, les monomères acryliques tels que l'acide acrylique ou ses sels, les acrylates d'alkyle, de cycloalkyle ou d'aryle tels que l'acrylate de méthyle, d'éthyle, de butyle, d'éthylhexyle ou de phényle, les acrylates d'hydroxyalkyle tels que l'acrylate de 2-hydroxyéthyle, les acrylates d'étheralkyle tels que l'acrylate de 2-méthoxyéthyle, les acrylates d'alcoxy- ou aryloxy-polyalkylèneglycol tels que les acrylates de méthoxypolyéthylèneglycol, les acrylates d'éthoxypolyéthylèneglycol, les acrylates de méthoxypolypropylèneglycol, les acrylates de méthoxypolyéthylèneglycol-polypropylèneglycol ou leurs mélanges, les acrylates d'aminoalkyle tels que l'acrylate de 2-(diméthylamino)éthyle (ADAME), les acrylates fluorés, les acrylates silylés, les acrylates phosphorés tels que les acrylates de phosphate d'alkylèneglycol,les acrylates de glycidyle, de dicyclopentenyloxyethyle, les monomères méthacryliques comme l'acide méthacrylique ou ses sels, les méthacrylates d'alkyle, de cycloalkyle, d'alcényle ou d'aryle tels que le méthacrylate de méthyle (MAM), de lauryle, de cyclohexyle, d'allyle, de phényle ou de naphtyle, les méthacrylates d'hydroxyalkyle tels que le méthacrylate de 2-hydroxyéthyle ou le méthacrylate de 2-hydroxypropyle, les méthacrylates d'étheralkyle tels que le méthacrylate de 2-éthoxyéthyle, les méthacrylates d'alcoxy-ou aryloxy-polyalkylèneglycol tels que les méthacrylates de méthoxypolyéthylèneglycol, les méthacrylates d'éthoxypolyéthylèneglycol, les méthacrylates de méthoxypolypropylèneglycol, les méthacrylates de méthoxypolyéthylèneglycol-polypropylèneglycol ou leurs mélanges, les méthacrylates d'aminoalkyle tels que le méthacrylate de 2-(diméthylamino)éthyle (MADAME), les méthacrylates fluorés tels que le méthacrylate de 2,2,2-trifluoroéthyle, les méthacrylates silylés tels que le 3-méthacryloylpropyltriméthylsilane, les méthacrylates phosphorés tels que les méthacrylates de phosphate d'alkylèneglycol, le méthacrylate d'hydroxy-éthylimidazolidone, le méthacrylate d'hydroxy-éthylimidazolidinone, le méthacrylate de 2-(2-oxo-1-imidazolidinyl)éthyle, l'acrylonitrile, l'acrylamide ou les acrylamides substitués, la 4-acryloylmorpholine, le N-méthylolacrylamide, le méthacrylamide ou les méthacrylamides substitués, le N-méthylolméthacrylamide, le chlorure de méthacrylamido-propyltriméthyle ammonium (MAPTAC), les méthacrylates de glycidyle, de dicyclopentenyloxyethyle, l'acide itaconique, l'acide maléique ou ses sels, l'anhydride maléique, les maléates ou hémimaléates d'alkyle ou d'alcoxy- ou aryloxy-polyalkylèneglycol, la vinylpyridine, la vinylpyrrolidinone, les (alcoxy) poly(alkylène glycol) vinyl éther ou divinyl éther, tels que le méthoxy poly(éthylène glycol) vinyl éther, le poly(éthylène glycol) divinyl éther, les monomères oléfiniques, parmi lesquels on peut citer l'éthylène, le butène, l'hexène et le 1-octène, les monomères dièniques dont le butadiène, l'isoprène ainsi que les monomères oléfiniques fluorés, et les monomères vinylidénique, parmi lesquels on peut citer le fluorure de vinylidène, ou une combinaisons de ces monomères.

La polymérisation des PAn est de préférence faite par polymérisation radicalaire contrôlée, que ce soit par les nitroxides, RAFT (reversible addition fragmentation transfert) ou encore ATRP (polymérisation radicalaire par transfert d'atomes).

Selon un premier aspect de l'invention, la polymérisation radicalaire contrôlée se fait à partir des alcoxyamines dérivées du radical libre stable (1).

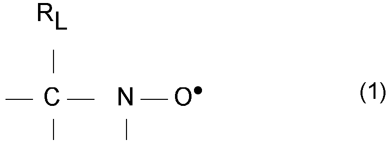

Dans laquelle le radical R_{L} présente une masse molaire supérieure à 15,0342 g/mole. Le radical R_{L} peut être un atome d'halogène tel que le chlore, le brome ou l'iode, un groupement hydrocarboné linéaire, ramifié ou cyclique, saturé ou insaturé tel qu'un radical alkyle ou phényle, ou un groupement ester -COOR ou un groupement alcoxyle -OR, ou un groupement phosphonate -PO(OR)₂, dès lors qu'il présente une masse molaire supérieure à 15,0342. Le radical R_{L}, monovalent, est dit en position β par rapport à l'atome d'azote du radical nitroxyde. Les valences restantes de l'atome de carbone et de l'atome d'azote dans la formule (1) peuvent être liées à des radicaux divers tels qu'un atome d'hydrogène, un radical hydrocarboné comme un radical alkyle, aryle ou aryle-alkyle, comprenant de 1 à 10 atomes de carbone. Il n'est pas exclu que l'atome de carbone et l'atome d'azote dans la formule (1) soient reliés entre eux par l'intermédiaire d'un radical bivalent, de façon à former un cycle. De préférence cependant, les valences restantes de l'atome de carbone et de l'atome d'azote de la formule (1) sont liées à des radicaux monovalents. De préférence, le radical R_{L} présente une masse molaire supérieure à 30 g/mole. Le radical R_{L} peut par exemple avoir une masse molaire comprise entre 40 et 450 g/mole. A titre d'exemple, le radical R_{L} peut être un radical comprenant un groupement phosphoryle, ledit radical R_{L} pouvant être représenté par la formule : 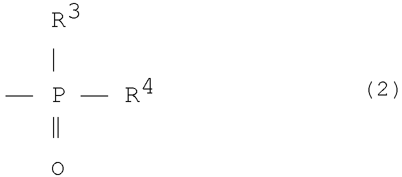 dans laquelle R³ et R⁴, pouvant être identiques ou différents, peuvent être choisis parmi les radicaux alkyle, cycloalkyle, alkoxyle, aryloxyle, aryle, aralkyloxyle, perfluoroalkyle, aralkyle, et peuvent comprendre de 1 à 20 atomes de carbone. R³ et/ou R⁴ peuvent également être un atome d'halogène comme un atome de chlore ou de brome ou de fluor ou d'iode. Le radical R_{L} peut également comprendre au moins un cycle aromatique comme pour le radical phényle ou le radical naphtyle, ce dernier pouvant être substitué, par exemple par un radical alkyle comprenant de 1 à 4 atomes de carbone.

Plus particulièrement les alcoxyamines dérivées des radicaux stables suivants sont préférées :
- N-tertiobutyl-1-phényl-2 méthyl propyl nitroxyde,
- N-tertiobutyl-1-(2-naphtyl)-2-méthyl propyl nitroxyde,
- N-tertiobutyl-1-diéthylphosphono-2,2-diméthyl propyl nitroxyde,
- N-tertiobutyl-1-dibenzylphosphono-2,2-diméthyl propyl nitroxyde,
- N-phényl-1-diéthyl phosphono-2,2-diméthyl propyl nitroxyde,
- N-phényl-1-diéthyl phosphono-1-méthyl éthyl nitroxyde,
- N-(1-phényl 2-méthyl propyl)-1-diéthylphosphono-1-méthyl éthyl nitroxyde,
- 4-oxo-2,2,6,6-tétraméthyl-1-piperidinyloxy,
- 2,4,6-tri-tert-butylphenoxy.

Les alkoxyamines utilisées en polymérisation radicalaire contrôlée doivent permettre un bon contrôle de l'enchaînement des monomères. Ainsi elles ne permettent pas toutes un bon contrôle de certains monomères. Par exemples les alcoxyamines dérivées du TEMPO ne permettent de contrôler qu'un nombre limité de monomères, il en va de même pour les alcoxyamines dérivées du 2,2,5-tri-methyl-4-phenyl-3-azahexane-3-nitroxyde (TIPNO). En revanche d'autres alcoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde permettent d'élargir à un grand nombre de monomère la polymérisation radicalaire contrôlée de ces monomères.
En outre la température d'ouverture des alcoxyamines influe également sur le facteur économique. L'utilisation de basses températures sera préférée pour minimiser les difficultés industrielles. On préfèrera donc les alkoxyamines dérivées des nitroxydes répondant à la formule (1), particulièrement celles dérivées des nitroxydes répondant à la formule (2) et encore plus particulièrement celles dérivées du N-tertiobutyl-1-diéthylphosphono-2,2-diméthyl propyl nitroxyde à celles dérivées du TEMPO ou 2,2,5-tri-methyl-4-phenyl-3-azahexane-3-nitroxyde (TIPNO).

Selon une seconde forme de l'invention, la polymérisation radicalaire contrôlée se fait par RAFT, et plus particulièrement avec un agent RAFT répondant à la formule II suivante : 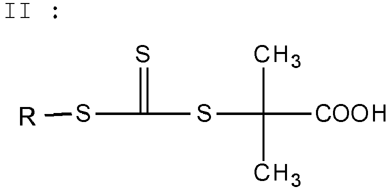 Où R représente un groupement Alkyle comportant 1 à 22 atomes de carbone, et de préférence 10 à 18 atomes de carbone, et de façon encore préférée 12 atomes de carbone.

Les compositions PEDOT:PAn objet de l'invention peuvent être utilisées pour disperser des nanocharges, telles que les nanotubes de carbone, qu'ils soient mono ou multi paroi, les graphènes, les nanofils d'argent. Les films obtenus à partir de ces compositions présentent une bonne transparence et une bonne conductivité. Les compositions de l'invention peuvent en outre contenir des additifs, en particulier de l'éthylène glycol.

### Exemple 1 :

### Polymérisation du 4-styrène-sulfonyle (trifluorométhyle-sulfonyle) imide de potassium par RAFT avec l'acide 2-(Dodécyle-sulfanyle-thiocarbonyle-sulfanyl)-2-méthyle propionique :

La synthèse du monomère 4-styrène-sulfonyle (trifluorométhyle-sulfonyle) imide de potassium nommé STFSIK est réalisée conformément à la littérature et est décrite dans l'article de R.meziane et al., Electrochimica Acta, 2011, 57, 14-19.
L'agent RAFT (acide 2-(Dodécyle-sulfanyle-thiocarbonyle-sulfanyl)-2-méthyle propionique) est synthétisé conformément à la littérature et est décrite dans l'article de J.T. Lai et al., MAcromolecules, 2002, 35, 6754-6756.

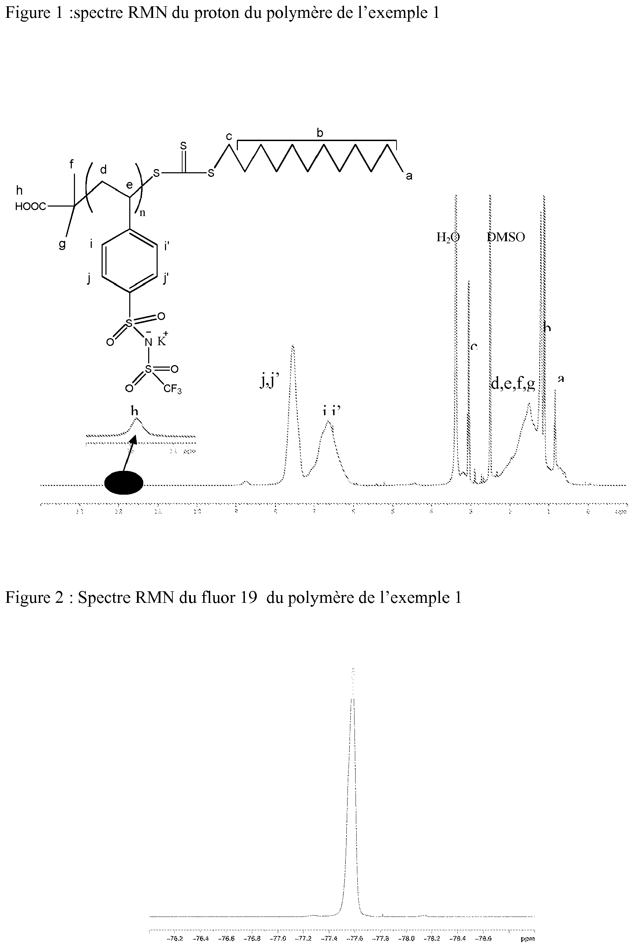

Dans un tube de Schlenk sec, on introduit 2g (5.66 mmole) de 4-styrène-sulfonyle (trifluorométhyle-sulfonyle) imide de potassium, 36.4 mg (0.1 mmole) d' acide 2-(Dodécyle-sulfanyle-thiocarbonyle-sulfanyl)-2-méthyle propionique, 3.28mg (0.02 mmole) d'AIBN (Azo-bis isobutyronitrile), et 4 ml de diméthyle formamide (DMF). Le tube de schlenk est ensuite inerté et placé dans un bain d'huile à 65°C. Après totale conversion (24h), le tube de schlenk est plongé dans de l'azote liquide. Le polymère PSTFSIK (Poly 4-styrène-sulfonyle (trifluorométhyle-sulfonyle) imide de potassium) est lavé deux fois par précipitation puis filtration avec de l'éther. Le polymère est ensuite séché à 60°C dans une étuve sous vide. La structure du polymère est confirmée par RMN du proton (figure 1) et du fluor 19 (figure 2).
La masse moléculaire en nombre mesurée par SEC avec des étalon polystyrène est de 20000g/mol, et l'indice de polydispersité est de 1.1.

### Exemple 2 : Polymérisation de l'EDOT en présence du PSTFSIK:

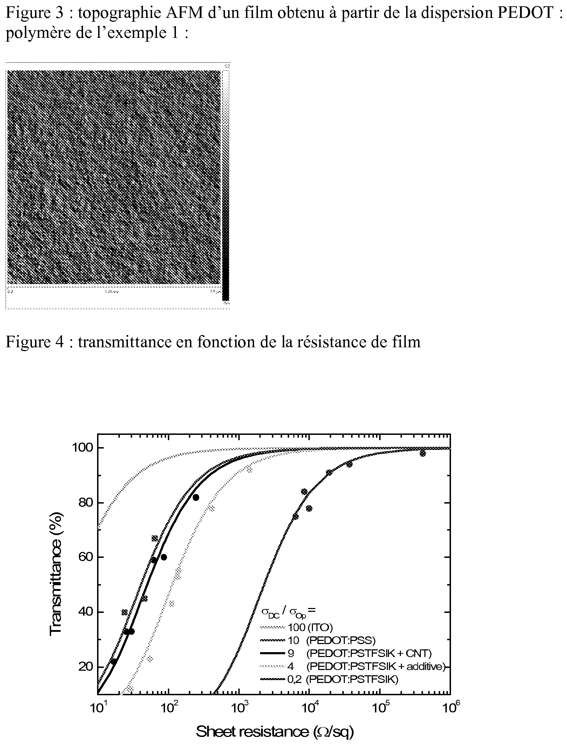

-Dans un ballon à une tubulure, on introduit 1.65g (Mn 20000 g/mol) du PSTFSIK dissout dans 150ml d'eau dé-ionisée, 0.3 ml (2.81 mmol) d'EDOT (sigma aldrich) sous agitation. Un mélange de persulfate d'ammonium (640mg, 2.81 mmole) et de chlorure ferrique (136mg, 0.84 mmole)est ensuite introduit. LE mélange réactionnel est vigoureusement agité durant 48 h, sous atmosphère d'azote à 25°C. Il en résulte une dispersion bleu foncé. La dispersion résultante de PEDOT et du PSTFSIK est lavée pas ultrafiltration avec une membrane Millipore de cellulose régénérée NMWL :100000 (molecular weight cut-off) en présence d'eau dé-ionisée pour éliminer les sels provenant des oxydants et du PSTFSIK non relié au PEDOT. Le rendement final en solide est de 85 %. On prépare un film avec cette dispersion par « spin coating » et on le soumet à de l'imagerie AFM. En figure 3, on observe la taille des particules qui varient de 40 à 50 nm.

Le latex PEDOT-Polystyrène co Polystyrène sulfonate préparé à l'exemple 1 est comparé au latex commercial (PEDOT-Polystyrène co Polystyrène sulfonate).
Ces produits sont dispersés dans l'eau dé-ionisée (1% massique) et soumis à un cisaillement à l'aide d'un ultraturax IKA T18, à différentes vitesses (15500, 20000, 24000 tr/min) durant 5 minutes pour chaque vitesse.
Dans ces conditions, que ce soit pour le latex commercial ou le latex objet de l'invention, il n'a pas été possible d'observer le moindre agglomérat démontrant la très bonne stabilité de ces deux latex.

### Exemple 3 : Dispersion de nanotubes de carbone monoparoi dans la dispersion de l'exemple 2 :

Des nanotubes de carbone multiparoi Graphistrengh® de la société Arkema sont dispersés dans de l'eau à l'aide de la dispersion de l'exemple 2 avec une excitation ultrasonique puissante durant plusieurs minutes. Les agrégats résiduels sont éliminés par ultracentrifugation. Des dispersions stables sont observés pour des concentrations en nanotubes de carbone jusqu'à 0.15% en poids dans une solution aqueuses contenant 0.26 % en poids de du couple PEDOT:PSTFSIK.

### Exemple 4 : conductivité du couple PEDOT : PSTFSIK en masse.

La conductivité électrique d'échantillons de PEDOT:PSTFSIK est mesurée par la méthode dite « 4 sondes » sur des échantillons de PEDOT:PSTFSIK pressés se présentant sous forme de disques de 1 mm d'épaisseur et 13 mm de diamètre. Les disques sont obtenus en utilisant une presse hydraulique de 10 tonnes. Les conductivités massiques de ces disques préparés selon différentes conditions expérimentales de synthèses sont exprimées au tableau 1.

| **Tableau 1. conductivité massique** | | | |
|---|---|---|---|
| Oxydant (ratio molaire par rapport à l'EDOT- 1:0.3 (APS/FeCl₃)),25°C | | | |
| Medium | Ratio molaire | Oxydant | Conductivité (S/cm) |
| | EDOT/STFSIK unit | (molar ratio vs EDOT) | |
| H₂O | 1/1 | 1:0.3 (APS/FeCl₃) | 14.65 |
| H₂O | 0.8/1 | 1:0.3 (APS/FeCl₃) | 15.33 |
| H₂O | 0.6/1 | 1:0.3 (APS/FeCl₃) | 34.83 |
| H₂O | 0.4/1 | 1:0.3 (APS/FeCl₃)) | 9.33 |
| H2O | 0.6/1 | 1.15 (APS) | Non-conducteur |
| H₂O | 0.6/1 | 2.3 (FeCl3) | Aggregations |
| H₂O | 0.6/1 | 2.3 (Fe(OTs)3) | 22.33 |
| H₂O/IPA (1/1) | 0.6/1 | 1:0.3 (APS/FeCl3) | Non-conducteur |
| H₂O/EG (1/0.1) | 0.6/1 | 1:0.3 (APS/FeCl3) | Non-conducteur |

| | | | |
|---|---|---|---|
| IPA : alcool isopropylique EG : Ethylène glycol APS : persulfate d'ammonium Fe(Ots)₃: tosylate de fer | | | |

La meilleure conductivité est obtenue avec le couple oxydant APS/FeCl3 dans un ratio 1:0.3 quand le ratio molaire EDOT et STFSIK est de 0.6:1. Aucune conductivité n'est observée quand la synthèse est effectuée soit dans un mélange eau/isopropanol ou eau/éthylène glycol.

### Exemple 5 : conductivité du couple PEDOT:PSTFSIK et de la dispersion de nanotubes de carbone dans la dispersion PEDOT:PSTFSIK.

Des films minces de PEDOT:PSTFSIK sont préparés par « spray coating) des dispersions PEDOT:PSTFSIK avec 10% massique d'éthylène glycol sur une plaque de verre placée sur une platine chauffée à 100°C. La résistance est mesurée par la technique des 4 sondes et la transmission est mesurée à 550 nm à l'aide d'un spectrophotomètre SHIMDZU UV-Vis-NIR UV- 3600.

De la même manière, on fabrique des films minces à partir des dispersions contenant des nanotubes de carbone tels que réalisés dans l'exemple 3 et on mesure la conductivité et la transmission.

On trouvera le tracé des courbes en figure 4.

On notera en particulier le bon comportement des formulations contenant des nanotubes de carbone (CNT) comparativement au PEDOT:PSS PH1000 de la société Clevios (noté PEDOT : PSS).

## Revendications

1. Composition PEDOT:polyanion dans laquelle le polyanion comprend le monomère tyrène-sulfonyle (trifluorométhyle-sulfonyle) imide de potassium.

2. Composition selon la revendication 1 dans laquelle le polyanion est polymérisé par polymérisation radicalaire contrôlée par les nitroxides.

3. Composition selon la revendication 2 dans laquelle le nitroxide est le N-tertiobutyl-1-diéthylphosphono-2,2-diméthyl propyl nitroxyde.

4. Composition selon la revendication 1 dans laquelle le polyanion est polymérisé par polymérisation radicalaire contrôlée de type RAFT.

5. Composition selon la revendication 4 dans laquelle l'agent RAFT correspond à la formule II suivante : 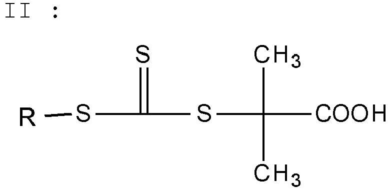 où R représente un groupement Alkyle comportant 1 à 22 atomes de carbone.

6. Composition selon la revendication 1 contenant en plus un additif.

7. Composition selon la revendication 6 dans lequel l'additif est l'éthylène glycol.

8. Film transparent conducteur obtenu à partir d'une composition selon l'une des revendications 1 à 7.

9. Utilisation d'une composition selon l'une des revendications 1 à 7 pour disperser des nanocharges.

10. Utilisation selon la revendication 9 dans laquelle les nanocharges sont constituées de nanotubes de carbone.

11. Film transparent conducteur obtenu à partir d'une composition selon l'une des revendications 1 à 7 et de nanotubes de carbone.

## Patentansprüche

1. PEDOT:Polyanion-Zusammensetzung, wobei das Polyanion das Monomer Tyrolsulfonyl-(Trifluormethylsulfonyl)-Imid des Kaliums umfasst.

2. Zusammensetzung nach Anspruch 1, wobei das Polyanion durch nitroxidgesteuerte Radikalpolymerisation polymerisiert wird.

3. Zusammensetzung nach Anspruch 2, wobei das Nitroxid N-Tertiärbutyl-1-diethylphosphono-2,2-dimethylpropylnitroxid ist.

4. Zusammensetzung nach Anspruch 1, wobei das Polyanion durch kontrollierte Radikalpolymerisation vom RAFT-Typ polymerisiert wird.

5. Zusammensetzung nach Anspruch 4, wobei das RAFT-Mittel der folgenden Formel II entspricht: 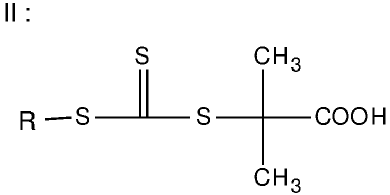 worin R eine Alkylgruppe mit 1 bis 22 Kohlenstoffatomen darstellt.

6. Zusammensetzung nach Anspruch 1, die zusätzlich ein Additiv enthält.

7. Zusammensetzung nach Anspruch 6, wobei das Additiv Ethylenglykol ist.

8. Transparente leitfähige Folie, erhalten aus einer Zusammensetzung nach einem der Ansprüche 1 bis 7.

9. Verwendung einer Zusammensetzung nach einem der Ansprüche 1 bis 7 zum Dispergieren von Nano-Füllstoffen.

10. Verwendung nach Anspruch 9, wobei die Nanofüllstoffe aus Kohlenstoff-Nanoröhrchen bestehen.

11. Transparenter leitfähiger Film, erhalten aus einer Zusammensetzung nach einem der Ansprüche 1 bis 7 und Kohlenstoff-Nanoröhren.

## Claims

1. A PEDOT:polyanion composition in which the polyanion comprises the monomer potassium 4-styrenesulfonyl (trifluoromethylsulfonyl)imide.

2. The composition as claimed in claim 1, in which the polyanion is polymerized by controlled radical polymerization with nitroxides.

3. The composition as claimed in claim 2, in which the nitroxide is N-tert-butyl-1-diethylphosphono-2,2-dimethylpropyl nitroxide.

4. The composition as claimed in claim 1, in which the polyanion is polymerized by controlled radical polymerization of RAFT type.

5. The composition as claimed in claim 4, in which the RAFT agent corresponds to formula II below: 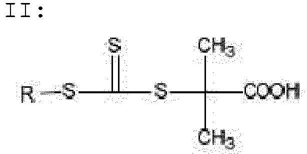 in which R represents an alkyl group comprising 1 to 22 carbon atoms.

6. The composition as claimed in claim 1, also containing an additive.

7. The composition as claimed in claim 6, in which the additive is ethylene glycol.

8. A conductive transparent film obtained from a composition as claimed in one of claims 1 to 7.

9. The use of a composition as claimed in one of claims 1 to 7 for dispersing nanofillers.

10. The use as claimed in claim 9, in which the nanofillers consist of carbon nanotubes.

11. A conductive transparent film obtained from a composition as claimed in one of claims 1 to 7 and carbon nanotubes.
